# DEMANDE DE BREVET EUROPEEN

(11) **EP 0 818 686 A1**
(43) Date de publication de la demande: **14.01.1998**
(21) Numéro de dépôt: 97401660.2
(22) Date de dépôt: 10.07.1997
(51) Int. Cl.: G01R 31/28

(54) **Dispositif de commutation notamment de système sous test**

(30) Priorité: 10.07.1996 FR 9608596
(71) Demandeur: AEROSPATIALE SOCIETE NATIONALE INDUSTRIELLE, 75016 Paris (FR)
(72) Inventeur: Bourgeois, Jean-François, 92170 Vanves (FR); Grain, Patrick, 78280 Guyancourt (FR); Lach, Jean-Louis, 92300 Levallois Perret (FR); Petit, Patrick, 94260 Fresnes (FR)
(74) Mandataire: Joly, Jean-Jacques

(57) **Abrégé**

Dispositif de commutation pour l'interconnexion automatique d'une première unité avec une seconde unité, ce dispositif ayant un premier ensemble d'entrées/sorties (16) relié à la première unité (12) et un second ensemble d'entrées/sorties (18) relié à la seconde unité (14), et comportant d'une part au moins une carte de commutation (20, 22, 24, 26, 26, 30) munie d'au moins un élément de commutation et d'autre part une unité (36) de commande de ces cartes pour réaliser ou non, en fonction d'ordres déterminés adressés à cette unité de commande, des interconnexions entre les première et seconde unités, cette unité de commande comportant en outre des moyens (42, 44, 46, 48) pour permettre une saisie de la configuration physique dudit dispositif de commutation et des moyens (42) pour, une fois cette saisie effectuée, assurer l'interconnexion automatique de la première unité (12) avec la seconde unité (14) selon les ordres adressés à l'unité de commande (36) par un utilisateur. Les moyens pour assurer l'interconnexion entre les première et seconde unités comportent des moyens (42) pour vérifier que les ordres de l'utilisateur sont compatibles avec la saisie préalable de la configuration physique du dispositif de commutation.

## Description

### Domaine de la technique

La présente invention concerne un dispositif de commutation permettant de relier ou d'interrompre des liaisons entre deux unités munies d'ensembles d'entrée/sortie, et notamment de permettre la commande ou le contrôle de systèmes sous test comme des équipements électroniques, des cartes électroniques ou des composants électroniques.

### Art antérieur

Les dispositifs de commutation actuels sont principalement constitués de cartes de commutation à relais ou, pour certaines applications particulières, de cartes de commutation à dispositifs à semi-conducteurs tels que des transistors de commutation. La commande de ces différentes cartes est effectuée par une programmation individuelle de ces cartes, par exemple à partir d'un ensemble informatique, en respectant une syntaxe de commande spécifique définie par le fabricant pour chaque type de carte. Il en résulte de très grandes difficultés de programmation, notamment lorsque le dispositif de commutation est complexe et qu'il comporte plusieurs dizaines de cartes de commutation provenant de fabricants différents et donc munies de syntaxes de commande distinctes. Le programmeur doit alors veiller seul à l'intégrité des différentes liaisons de commutation, la mise en fonctionnement du système sous test, une fois la programmation terminée, étant l'unique moyen de vérification réelle de l'exactitude de cette programmation et donc de garantie d'une réalisation correcte du test.

### Définition et objet de l'invention

La présente invention propose de réaliser un dispositif de commutation qui simplifie considérablement le travail de programmation initial et notamment évite le test en réel, à l'issue de la programmation, source de fréquentes détériorations du système sous test. Un but de l'invention est de réaliser un dispositif fiable et pouvant être utilisé par un utilisateur quelconque sans avoir à connaître les syntaxes de commande de chaque carte de commutation composant le dispositif. Un autre but de l'invention est de réaliser un dispositif de commutation qui assure de lui même la gestion des courts-circuits et des différentes relations de dépendance pouvant exister entre les éléments de commutation composant chaque carte. Encore un autre but de l'invention est de permettre une commande automatique du dispositif de commutation à l'issue de sa programmation.

Ces buts sont atteints par un dispositif de commutation pour l'interconnexion automatique d'une première unité avec une seconde unité, ce dispositif ayant un premier ensemble d'entrées/sorties relié à la première unité et un second ensemble d'entrées/sorties relié à la seconde unité, et comportant d'une part au moins une carte de commutation munie d'au moins un élément de commutation et d'autre part une unité de commande de ces cartes pour réaliser ou non, en fonction d'ordres déterminés adressés à cette unité de commande, des interconnexions entre les première et seconde unités, cette unité de commande comportant en outre des moyens pour permettre une saisie de la configuration physique du dispositif de commutation et des moyens pour, une fois cette saisie effectuée, assurer l'interconnexion automatique de la première unité avec la seconde unité selon les ordres adressés à l'unité de commande par un utilisateur.

Par cette séparation de la fonction de programmation (définition complète de la configuration physique du dispositif), qui est réalisée une seule fois pour un dispositif de commutation donné, et la fonction proprement dite d'exécution des commandes de l'utilisateur (par exemple la réalisation du test dans le cas où la seconde unité est un système sous test), il est possible d'obtenir une gestion automatique et une optimisation des commandes de l'utilisateur qui peut alors considérer le dispositif de commutation comme une simple "boîte noire".

Avantageusement, les moyens pour assurer l'interconnexion entre les première et seconde unités comportent des moyens pour vérifier que les ordres de l'utilisateur sont compatibles avec la saisie préalable de la configuration physique du dispositif de commutation. Ces moyens de vérification comporte notamment des moyens pour vérifier que les interconnexions n'entraînent pas de courts-circuits au niveau du dispositif de commutation. Les risques de destruction de la seconde unité (par exemple le système sous test) sont ainsi évités.

Les moyens de saisie de la configuration physique du dispositif de commutation comportent des moyens pour permettre une saisie de syntaxes de commande des cartes de commutation, des moyens pour permettre une saisie des liaisons d'interconnexion entre les éléments de commutation des cartes de commutation et des moyens pour permettre une saisie des liaisons d'interconnexion entre les cartes de commutation et avec les ensembles d'entrées/sorties. Il est ainsi réalisé une modélisation complète du dispositif de commutation et l'utilisateur n'a plus alors qu'à spécifier les liaisons entre les ensembles d'entrées/sorties qu'il désire voir effectuer (et non les liaisons internes au dispositif de commutation).

Les moyens de saisie des liaisons d'interconnexion entre les éléments de commutation comportent des moyens pour affecter des liens de dépendance à au moins deux déterminés de ces éléments de commutation dont la commande peut être réalisée en commun ou séparément (l'un ou l'autre). De même, les moyens de saisie des liaisons d'interconnexion entre les cartes de commutation comportent des moyens pour affecter des liens de dépendance à au moins deux déterminées de ces liaisons dont la réalisation est simultanée ou exclusive l'une de l'autre.

De préférence, l'unité de commande comporte en outre des moyens comportant au moins une bibliothèque de fonctions de base pour faciliter les saisies.

### Brève description des figures

D'autres caractéristiques et avantages de la présente invention ressortiront mieux de la description suivante, faite à titre indicatif et non limitatif, en regard des dessins annexés, sur lesquels:
- la figure 1 montre schématiquement un dispositif de commutation selon l'invention destiné à la commande d'un système sous test,
- la figure 2 montre une carte de commutation du dispositif de la figure 1, et
- la figure 3 est un ordinogramme explicitant les différentes étapes de programmation et de commande du dispositif de commutation de la figure 1.

### Description détaillée d'un mode de réalisation préférentiel

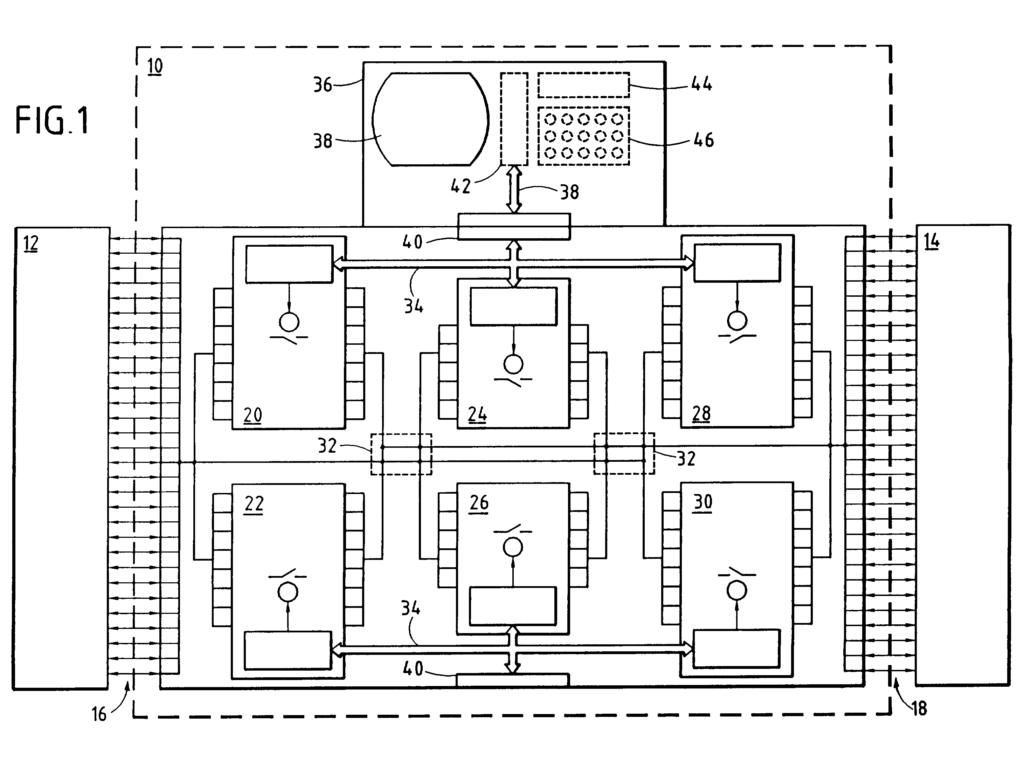

La figure 1 illustre de façon schématique un dispositif de commutation selon l'invention. Ce dispositif de commutation 10 est destiné à assurer des liaisons entre une première unité comme une unité d'analyse et de mesure 12 et une seconde unité comme un système sous test (dit aussi système à tester 14). Le système sous test peut être quelconque, par exemple un système électronique complexe comme un système aéronautique, un équipement électronique comme une baie de contrôle, une carte électronique ou même un composant électronique. L'unité d'analyse et de mesure peut comprendre tout type d'appareil d'analyse ou de mesure tels que des alimentations, des générateurs de signaux basse ou haute fréquence, des analyseurs de bus, des oscilloscopes, des fréquencemètres, des multimètres, des compteurs, etc.

Le dispositif selon l'invention peut aussi être mis en oeuvre pour réaliser par exemple un dispositif d'aiguillage, notamment en ayant recours à des éléments de commutation à transistors, pour l'analyse par un enregistreur en temps réel (faisant fonction de système sous test) de signaux de télémesure envoyés par différents systèmes aéronautiques et recueillis au niveau d'un ensemble d'acquisition (faisant fonction d'unité de mesure).

L'unité d'analyse et de mesure 12 est reliée au dispositif de commutation 10 par un premier ensemble d'entrée/sortie 16 et le dispositif de commutation est lui-même relié au système à tester 14 par un second ensemble d'entrée/sortie 18.

Le dispositif de commutation 10 comporte plusieurs cartes de commutation (par exemple les six cartes 20 à 30 illustrées sur la figure 1), ayant chacune plusieurs entrées et plusieurs sorties reliées directement au premier ou au second ensembles d'entrée/sortie, ou bien encore entres elles au moyen de platines de connexion 32, et permettant de réaliser ou d'interrompre les liaisons entre l'unité de mesure 12 et le système à tester 14, en fonction d'ordres déterminés reçus au travers d'un bus de communication commun 34 auquel toutes ces cartes de commutation sont également reliées. Ces différents ordres sont générés au niveau d'une unité de commande informatique 36 constituée avantageusement d'un ordinateur du type personnel (Par exemple un ordinateur P.C. de la compagnie IBM) ou d'une station de travail (par exemple des stations des sociétés américaines Hewlett-Packard et Sun) ou de tout autre machine de traitement analogue. Cette unité de commande qui est reliée directement au bus commun 34 par son propre bus interne 38 au niveau d'une interface de liaison 40 (classiquement cette interface sera constituée par la liaison dite "de fond de panier" de cet ordinateur) comporte de façon connue en soi des moyens de traitement 42, des moyens mémoire 44, des moyens d'entrée de données tel un clavier 46 et des moyens de sortie de données tel un écran de visualisation 48.

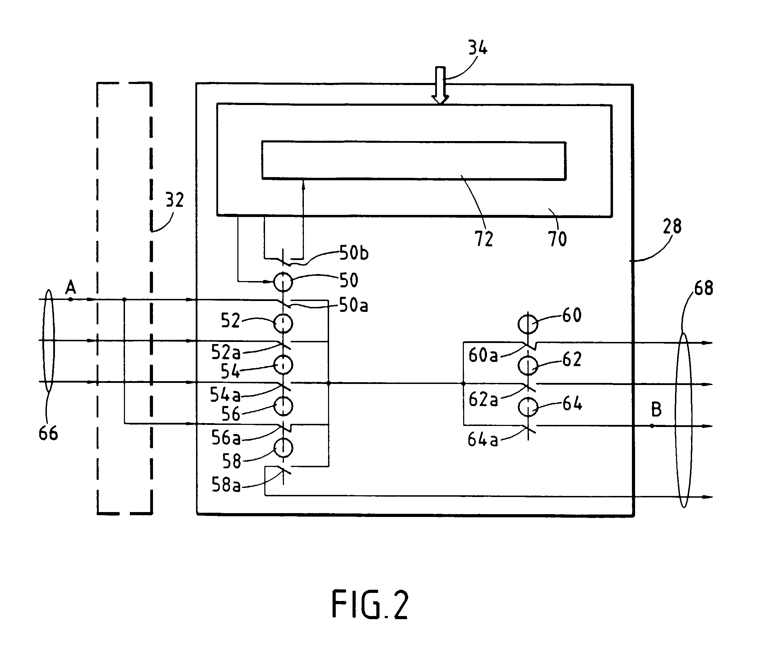

La figure 2 illustre plus précisément la structure d'une carte de commutation, par exemple celle référencée 28. Cette carte comporte au moins un élément de commutation 50 à 64 muni d'au moins un contact 50a à 64a assurant la liaison entre des entrées 66, éventuellement au travers de la platine de connexion 32, et des sorties 68. Bien entendu, tous les types de contact sont envisageables: contact à un ou deux pôles ou double contact par exemple, du type ouvert ou fermé au repos, de même que tous les types de cartes peuvent être utilisés: cartes à relais simple, cartes matrice, cartes multiplexeur, cartes à transistors. Les sociétés Tektronix, Racal Systems et Hewlett-Packard sont les principaux fournisseurs de ces cartes. La commande de chaque élément de commutation est effectuée individuellement au travers d'une interface de commande 70 qui est reliée au bus commun 34 soit par transfert de caractères du type adresse-données soit par lecture-écriture dans un registre spécifique de cette interface. Cette interface de commande comporte avantageusement une mémoire 72 qui emmagasine l'état, ouvert ou fermé, de chaque élément de commutation de la carte en relevant l'état d'un dispositif de recopie pouvant être un contact auxiliaire associé à chacun de ces éléments (pour ne pas alourdir la représentation seul le contact auxiliaire 50b est illustré).

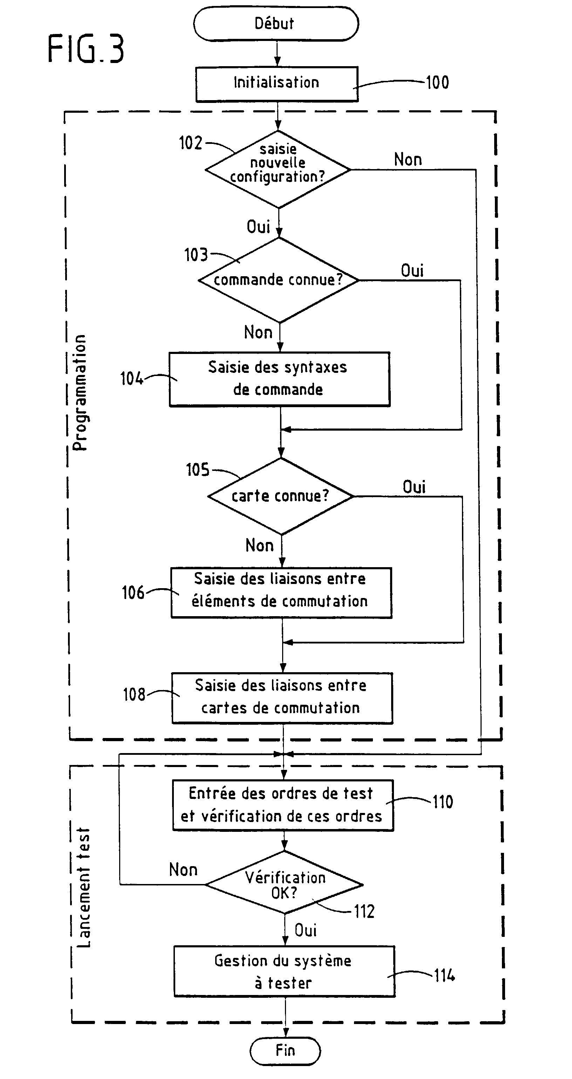

Le fonctionnement du dispositif de commutation selon l'invention est maintenant explicité au regard de la figure 3. Celui-ci se décompose essentiellement en deux parties distinctes et successives : une première partie (partie de programmation ou de modélisation) de saisie de la configuration physique du dispositif de commutation, c'est à dire de ces différents constituants (cartes et éléments de commutation, platine de connexion) et des liaisons entre ces constituants et une seconde partie (partie d'exécution par exemple pour lancement du test proprement dit) de commande du dispositif.

Après une étape 100 d'initialisation et qu'une saisie initiale (ou une modification) de la configuration physique du dispositif de commutation est souhaitée dans une étape 102, il est procédé dans une étape suivante 104, au niveau de l'unité de commande 36 (par l'intermédiaire de ses moyens d'entrée et de traitement) à une saisie des syntaxes de commande des différentes cartes de commutation mise en oeuvre dans ce dispositif. On sait que ces syntaxes dépendent à la fois du type de carte utilisé (la syntaxe d'une carte à relais est différente de celle d'une carte multiplexeur par exemple) et bien entendu du fabricant de ces cartes. La saisie de ces syntaxes implique de renseigner plusieurs paramètres permettant l'identification de la carte à laquelle est appliquée cette syntaxe, la récupération d'un éventuel code d'erreur, l'initialisation complète de la carte et les commandes de mise au repos ou au travail de chacun des éléments de commutation de cette carte. Des paramètres généraux relatifs à la date de cette première saisie, à sa révision ultérieure ou à son identification seront bien évidemment également prévus. Une bibliothèque de modèles de commande prédéterminés (fonctions de base) est disponible permettant éventuellement dans une étape préalable 103 d'éviter cette saisie si la syntaxe de commande est déjà connue. On aura noté que la saisie des syntaxes peut en principe être effectuée une fois pour toute, des saisies ultérieures ne se justifiant qu'en cas d'apparition d'un nouveau fabricant de cartes ou de modification, par les fabricants existants, de leur syntaxe d'origine (ce qui est rare pour des questions de compatibilité de gammes).

Cette étape de saisie des différentes syntaxes disponibles étant effectuée, il peut être passé à une étape suivante 106 de saisie des liaisons d'interconnexion entre les différents éléments de commutation d'une carte donnée. Cette nouvelle saisie effectuée également au niveau de l'unité de commande 36 consiste à définir pour chaque carte ses points d'entrée et de sortie (externes) et ses points de connexions (internes), que l'on nommera voies, et les chemins possibles entre ces différents points ou voies, que l'on nommera tronçons. Il sera aussi nécessaire de définir les liens de dépendance entre ces tronçons lorsque par exemple l'activation (ou l'inactivation) de l'un de ces tronçons doit entraîner l'activation d'un ou plusieurs autres tronçons. Grâce à ces informations, il est possible ensuite de savoir quels tronçons peuvent ou ne peuvent pas être activés simultanément et éviter ainsi tout court-circuit. Bien entendu, comme précédemment, il est prévu de renseigner des paramètres généraux de la carte de commutation comme son identification, sa date de saisie et de révision éventuelle, la référence du fabricant, la syntaxe et le type de bus de communication utilisés avec cette carte. On sait en effet que les cartes de commutation actuellement commercialisées mettent en oeuvre différents type de bus et notamment les bus IEEE, MXI, VXI, GPIB. De même, une bibliothèque de modèles de carte (fonctions de base) est également accessible dans une étape préalable 105 et permet si nécessaire lorsque la carte utilisée est déjà connue de supprimer cette étape de saisie. On aura compris que sauf à intégrer de nouveaux types de cartes de commutation, cette étape de saisie n'aura pas non plus à être renouvelée lors de chaque utilisation du dispositif de commutation.

Il est ensuite procédé, dans une étape 108, au niveau de l'unité de commande 36 à la saisie des liaisons d'interconnexion pouvant être effectuées entre les cartes de commutation. Ces liaisons, au contraire des précédentes, sont différentes selon le système à tester. Comme précédemment, on définira des voies, mais aussi les connexions entre toutes les entrées/sorties du dispositif de commutation, ces connexions pouvant être affectées comme les tronçons d'un lien de dépendance qui peut entraîner leur activation commune ou au contraire leur exclusion mutuelle. Des paramètres généraux d'identification, de date de création, d'indice de révision, de nombre de cartes gérées avec l'adresse affectée à chaque carte seront également renseignés.

Lorsque les saisies précédentes des syntaxes de commande, des liaisons entre éléments de commutation et entre cartes de commutation sont achevées ou que la création ou la modification d'une configuration physique du dispositif selon l'invention n'a pas été demandée lors de l'étape 102, il est alors possible, dans une étape 110, de permettre à l'utilisateur de lancer le test proprement dit, en effectuant les commandes nécessaires à sa réalisation (c'est à dire en délivrant les ordres de test adéquats). Il est très important de remarquer que si les étapes de saisie précédentes 104 à 108 nécessitent le recours à un programmeur, il n'en est plus ainsi de cette étape de lancement du test qui peut être exécutée par tout utilisateur du dispositif de commutation. En effet, cet utilisateur n'a plus comme par le passé à commander l'un après l'autre les relais nécessaires à la réalisation d'une liaison entre une entrée du dispositif de commutation et une sortie de ce même dispositif, mais simplement à mentionner que telle entrée doit être reliée à telle sortie. Ce nouveau processus de commande sera illustré très simplement en regard de la figure 2. Avec les dispositifs de commutation de l'art antérieur, pour relier l'entrée A à la sortie B, il était nécessaire de donner successivement les trois ordres suivants : ouvrir C28; 56 (ouvrir le relais 56 de la carte 28); fermer C28, 50; fermer C28, 64. Avec le dispositif de commutation selon l'invention un seul ordre "relier A à B" permet de réaliser la même liaison. Cet exemple est volontairement simple, mais on comprendra aisément tout l'intérêt de l'invention dès lors que le dispositif de commutation comporte plusieurs dizaines de cartes avec chacune plus de dix éléments de commutation. Dans ce cas, le gain de temps pour l'utilisateur est considérable. Surtout, celui-ci n'a plus à être un programmeur spécialisé connaissant les structures matérielles de chaque carte de commutation et leurs syntaxes de commande. Les différentes commandes nécessaires au test étant fournies par l'utilisateur au niveau des moyens d'entrée 46, le dispositif de commutation par l'intermédiaire de son module de traitement 42 va pouvoir vérifier que les ordres donnés sont bien exécutables dans une étape 112, et si il en est ainsi pouvoir lancer leur exécution réelle dans l'étape terminale 114. Cet aspect nouveau de l'invention est également très important, car contrairement au dispositif de commutation de l'art antérieur, où la vérification de la programmation effectuée par le programmeur est réalisée lors du test réel (d'où des risques très réels et en pratique fréquents de destruction du système à tester), avec la présente invention, il peut être procédé, au niveau de l'unité de commande 36, à une vérification préalable des ordres de test entrés par l'utilisateur en fonction de la configuration physique du dispositif de commutation saisie préalablement. Ce n'est que lorsque ces ordres sont validés, et notamment qu'il est vérifié que les différentes interconnexions n'entraînent pas de court-circuits au niveau du dispositif, que le test réel peut être lancé.

La fiabilité du dispositif est de ce fait notablement augmentée et les risques de destruction du système à tester totalement supprimés. On aura noté la simplicité de l'emploi par les utilisateurs du dispositif de commutation de l'invention tant en ce qui concerne la mise en oeuvre (notamment la programmation est facilitée par le recours à des bibliothèques de fonctions prédéfinies) que la gestion du dispositif (notamment par une optimisation des commandes des différentes cartes de commutation).

## Revendications

1. Dispositif de commutation pour l'interconnexion automatique d'une première unité avec une seconde unité, ce dispositif ayant un premier ensemble d'entrées/sorties (16) relié à la première unité (12) et un second ensemble d'entrées/sorties (18) relié à la seconde unité (14), et comportant d'une part au moins une carte de commutation (20, 22, 24, 26, 26, 30) munie d'au moins un élément de commutation (50, 52, 54, 56, 58, 60, 62, 64) et d'autre part une unité (36) de commande de ces cartes pour réaliser ou non, en fonction d'ordres déterminés adressés à cette unité de commande, des interconnexions entre les première et seconde unités, caractérisé en ce que ladite unité de commande comporte en outre des moyens (42, 44, 46, 48) pour permettre une saisie de la configuration physique dudit dispositif de commutation et des moyens (42) pour, une fois cette saisie effectuée, assurer l'interconnexion automatique de la première unité (12) avec la seconde unité (14) selon les ordres adressés à l'unité de commande (36) par un utilisateur.

2. Dispositif de commutation selon la revendication 1, caractérisé en ce que lesdits moyens pour assurer l'interconnexion entre les première et seconde unités comportent des moyens (42) pour vérifier que les ordres de l'utilisateur sont compatibles avec la saisie préalable de la configuration physique du dispositif de commutation.

3. Dispositif de commutation selon la revendication 2, caractérisé en ce que lesdits moyens de vérification comporte notamment des moyens (42) pour vérifier que lesdites interconnexions n'entraînent pas de courts-circuits au niveau du dispositif de commutation.

4. Dispositif de commutation selon la revendication 1, caractérisé en ce que lesdits moyens de saisie de la configuration physique du dispositif de commutation comportent des moyens (42, 46) pour permettre une saisie de syntaxes de commande desdites cartes de commutation, des moyens (42, 46) pour permettre une saisie des liaisons d'interconnexion entre lesdits éléments de commutation desdites cartes de commutation et des moyens (42, 46) pour permettre une saisie des liaisons d'interconnexion entre lesdites cartes de commutation et avec lesdits ensembles d'entrées/sorties (16, 18).

5. Dispositif de commutation selon la revendication 4, caractérisé en ce que lesdits moyens de saisie des liaisons d'interconnexion entre lesdits éléments de commutation comportent des moyens (42) pour affecter des liens de dépendance entre au moins deux déterminés de ces éléments de commutation dont la commande peut être réalisée en commun ou séparément (l'un ou l'autre).

6. Dispositif de commutation selon la revendication 4, caractérisé en ce que lesdits moyens de saisie des liaisons d'interconnexion entre lesdites cartes de commutation comportent des moyens (42) pour affecter des liens de dépendance entre au moins deux déterminées de ces liaisons dont la réalisation est simultanée ou exclusive l'une de l'autre.

7. Dispositif de commutation selon les revendications 5 ou 6, caractérisé en ce que ladite unité de commande comporte en outre des moyens (44) comportant au moins une bibliothèque de fonctions de base pour faciliter lesdites saisies.

8. Application du dispositif de commutation selon l'une quelconque des revendications 1 à 7 à la commande d'un système sous test (14), tel un sous-ensemble électronique, à partir d'une unité de mesure et d'analyse (12).
